# EUROPEAN PATENT APPLICATION

(11) **EP 0 772 052 A1**
(43) Date of publication of application: **07.05.1997**
(21) Application number: 96115904.3
(22) Date of filing: 04.10.1996
(51) Int. Cl.: G01R 21/127

(54) **Improvements in or relating to electricity meters**

(30) Priority: 02.11.1995 GB 9522441
(71) Applicant: SIEMENS MEASUREMENTS LIMITED, Oldham, Lancashire OL9 7JS (GB)
(72) Inventor: Graham, Ian, Ramsbottom, Bury Lancs, BLO 9YB (GB); Harrison, Leigh, Sale, Cheshire, M33 GLL (GB); Bain, David, Ramsbottom, Bury Lancs, BLO 9FH (GB)
(74) Representative: Allen, Derek

(57) **Abstract**

An electricity meter for the measurement of electrical energy (1) supplied to a consumer (2) comprising a first measurement circuit (3) which produces a first analogue signal the amplitude of which is representative of supplied current, a second measurement circuit (4) which produces a second analogue signal representative of supplied voltage, a triangular waveform reference signal generator (14) , two comparators (10,13) to which said first and second analogue signals respectively and the triangular waveform reference signal are fed so that the comparators each produce a pulse-width modulated output signal characteristic of current and voltage respectively, the mark/space ratio of which is determined in dependance upon the amplitude of the analogue signal fed thereto, the output signals each being repeatedly sampled to produce in respect of voltage and current, during consecutive periods corresponding to each cycle of the triangular waveform reference signal a plurality of samples, corresponding current and voltage samples for each period being mutually multiplied and integrated thereby to provide a signal indicative of energy supplied.

## Description

This invention relates to electricity meters and more especially it relates to electricity meters for measuring the energy supplied by a utility to a consumer.

According to the present invention an electricity meter for the measurement of electrical energy supplied to a consumer comprises a first measurement circuit which produces a first analogue signal the amplitude of which is representative of supplied current, a second measurement circuit which produces a second analogue signal representative of supplied voltage, a triangular waveform reference signal generator, two comparators to which said first and second analogue signals respectively and the triangular waveform reference signal are fed so that the comparators each produce a pulse-width modulated output signal characteristic of current and voltage respectively, the mark/space ratio of which is determined in dependance upon the amplitude of the analogue signal fed thereto, the output signals each being repeatedly sampled to produce in respect of voltage and current, during consecutive periods corresponding to each cycle of the triangular waveform reference signal a plurality of samples, corresponding current and voltage samples for each period being mutually multiplied and integrated thereby to provide a signal indicative of energy supplied.

The first measurement circuit may comprise a shunt via which supply current is fed to a consumer, a voltage dropped across the shunt being used to provide the first analogue signal.

The voltage dropped across the shunt may be fed via a filter and a scaling attenuator to provide the first analogue signal the attenuator being operable under the control of a micro-processor which selects appropriate attentuation steps, thereby to control the amplitude of the said first analogue signal.

The voltage dropped across the shunt and the second analogue signal may each be filtered by means of low pass filters so that higher frequency ripple signals are excluded from the comparators.

The triangular waveform reference signal generator may comprise a rectangular signal generator which feeds a signal shaper to produce the reference signal at a frequency f₁.

Sampling means for repeatedly sampling the pulse-width modulated comparator output signals may comprise a pair of counters responsive to respective output signals and to gating pulses of period 1/f₁ for counting pulses produced by a clock pulse oscillator at a frequency f₂ which is very much higher than f₁, during those parts of the period 1/f₁ when said output signals correspond to a 'mark', the counters being reset at the end of each 1/f₁ period, their respective counts immediately prior to each resetting operation being mutually multiplied and integrated thereby to provide the signal indicative of energy supplied.

The multiplication and integration functions may be carried out in the micro-processor.

Additionally the counting operations may be carried out in the micro-processor.

Alternatively the counter functions may be at least partly carried out by appropriate hardware apparatus external of the micro-processor.

In order to calibrate the meter at least one and preferably both of the counters may be 'offset' so that the effective count state is greater or less, as necessary, than a count state registered just prior to resetting.

One embodiment of the invention will now be described by way of example only with reference to the accompanying drawings wherein,
FIGURE 1 is a somewhat schematic circuit/block diagram of an electricity meter and,
FIGURE 2 is a waveform diagram appertaining to Figure 1.

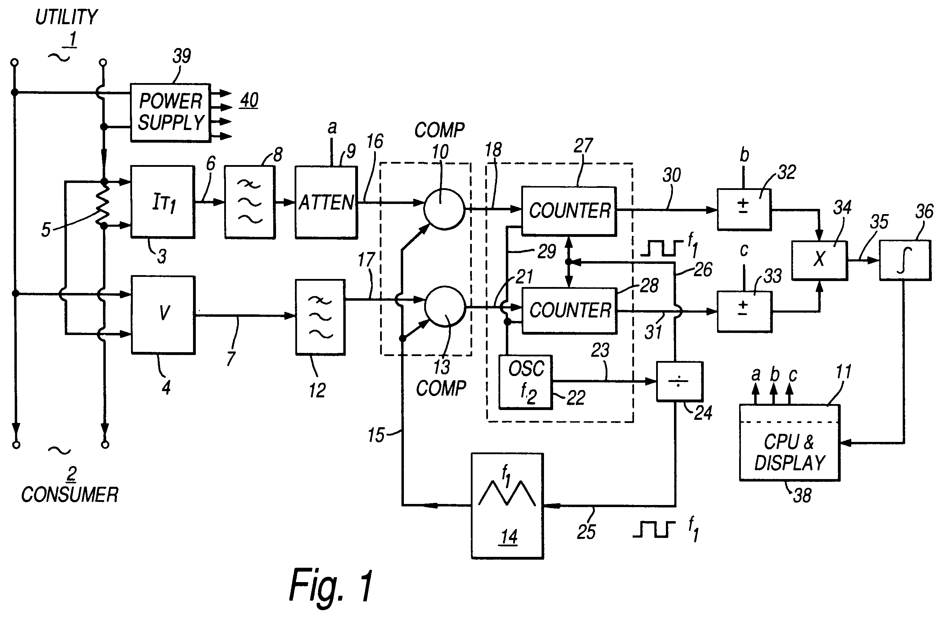

Referring now to Figure 1 an electricity meter for measuring the quantity of electrical energy supplied via terminals 1 from a utility to terminals 2 which are connected to a consumer comprises an analogue current measuring circuit 3 and an analogue voltage measuring circuit 4. The current measuring circuit 3 is connected to sense a voltage dropped across a shunt resistor 5 via which current is supplied from the terminals 1 to the terminals 2. The shunt resistor 5 is of very low resistance so that, taking account of the maximum current to be supplied, insignificant power is dissipated therein. The measuring circuits 3 and 4 are arranged to provide on lines 6 and 7 signals the amplitude of which correspond to current and voltage respectively. The current representative signal on the line 6 is fed via a low pass filter 8 and a controlled attenuator 9 to a first comparator 10. The controlled attenuator is controlled by a central processor unit 11 via a line 'a' in steps so that the dynamic range of signals applied to the comparator 10 are suitably scaled so that its dynamic capability is not exceeded.

Similarly, the signal level on the line 7 representative of supply voltage is fed via a low pass filter 12 to a second comparator 13. The low pass filters 8 and 12 serve to remove ripple and other spurious signals from the lines 6 and 7 respectively. The comparators 10 and 13 are fed from a triangular waveform reference signal generator 14 which provides on a line 15 a triangular reference signal for the comparators 10 and 13. Signals are provided on lines 16 and 17 which feed the comparators 10 and 13 respectively the level of which correspond to supply current and supply voltage respectively.

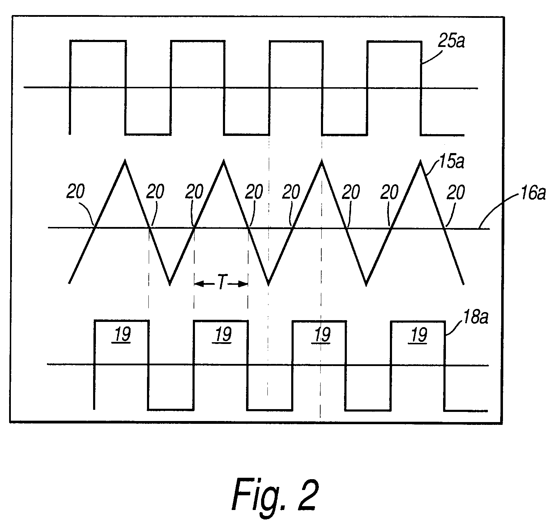

Referring now to Figure 2 a triangular waveform 15a is shown which corresponds to the triangular reference signal on the line 15. Additionally, a substantially level amplitude signal 16a is shown which corresponds to the signal level on the line 16 which is representative of supply current. In operation of the comparator 10, to which these signals 15a and 16a are applied, an output rectangular wave is produced on a line 18 corresponding to the rectangular waveform 18a shown in Figure 2. In operation of the comparator 10, pulses 19 are produced on the line 18 the width of which correspond to the period between crossing points 20 at which the signal level 16a corresponds to the signal level of the waveform 15a. Thus it will be appreciated that the mark/space ratio of the waveform 18 will be varied in accordance with the amplitude of the signal level 16a. The comparator 13 operates in a similar way so that signals are produced on an output line 21 from the comparator 13 the mark/space ratio of which varies with supply voltage at the terminals 1. The triangular waveform reference signal provided by the generator 14 at a frequency f₁ is derived from a crystal controlled master oscillator 22 which runs at a frequency f₂ which is much higher than the frequency f₁. In this particular embodiment the frequency f₁ is 1024Hz whereas the frequency f₂ is 4.194MHz but alternative frequencies may be chosen in accordance with the particular application in view. Signals from the oscillator 22 are fed via a line 23 to a frequency divider 24 so as to provide a rectangular waveform 25a (Figure 2) at the frequency f₁ on a line 25 which feeds the reference signal generator 14. The frequency divider is also arranged to provide on a line 26 a resetting signal at the frequency f₁ which is applied to a pair of counters 27 and 28. The counters are fed also from the oscillator 22 with clock pulses at the frequency f₂ via a line 29. Additionally, the counters 27 and 28 are fed with signals on the lines 18 and 21 respectively such that while these signals are 'high', corresponding to a 'mark', the counters operate to count clock pulses on the line 29 from the oscillator 22. The counters are reset at intervals of 1/f₁ so that digital count states delivered on lines 30 and 31 correspond to current and voltage respectively. The signals on the lines 30 and 31 are fed via count offset devices 32 and 33 respectively, to a multiplier 34. An output signal is provided by the multiplier 34 on a line 35 in respect of corresponding consecutive voltage and current counts, which signal corresponds to power consumed and signals on the line 35 are integrated with respect to time in an integrator 36 to provide a signal indicative of energy consumed. The integrator 36 feeds the CPU 11 and a display panel 38 which is incremented in accordance with the quantity of electrical energy used.

The offset units 32 and 33 are included so that the count states on the lines 30 and 31 may be incremented or decremented as appropriate, via lines 'b' and 'c' respectively from the CPU 11. Count incrementing or decrementing in this way facilitates calibration. Power for the various parts of the meter is provided by a power supply 39 which is arranged to feed power at the voltages required via lines 40 to various parts of the meter.

In one contemplated embodiment of the invention the multiplier 34 the integrator 36 the oscillator 22 the offset units 32, 33 and the counters 27, 28 are included in a micro-processor which also embodies the CPU 11. As will be appreciated by those skilled in the art, the micro-processor may be programmed to provide the necessary functions required for operation of the meter.

## Claims

1. An electricity meter for the measurement of electrical energy supplied to a consumer comprising a first measurement circuit which produces a first analogue signal the amplitude of which is representative of supplied current, a second measurement circuit which produces a second analogue signal representative of supplied voltage, a triangular waveform reference signal generator, two comparators to which said first and second analogue signals respectively and the triangular waveform reference signal are fed so that the comparators each produce a pulse-width modulated output signal characteristic of current and voltage respectively, the mark/space ratio of which is determined in dependance upon the amplitude of the analogue signal fed thereto, the output signals each being repeatedly sampled to produce in respect of voltage and current, during consecutive periods corresponding to each cycle of the triangular waveform reference signal a plurality of samples, corresponding current and voltage samples for each period being mutually multiplied and integrated thereby to provide a signal indicative of energy supplied.

2. An electricity meter as claimed in claim 1 wherein the first measurement circuit comprises a shunt via which supply current is fed to a consumer, a voltage dropped across the shunt being used to provide the first analogue signal.

3. An electricity meter as claimed in claim 2 wherein the voltage dropped across the shunt is fed via a filter and a scaling attenuator to provide the first analogue signal the attenuator being operable under the control of a micro-processor which selects appropriate attentuation steps, thereby to control the amplitude of the said first analogue signal.

4. An electricity meter as claimed in claim 2 or claim 3 wherein the voltage dropped across the shunt and the second analogue signal are each filtered by means of low pass filters so that higher frequency ripple signals are excluded from the comparators.

5. An electricity meter as claimed in any preceding claim wherein the triangular waveform reference signal generator comprises a rectangular signal generator which feeds a signal shaper to produce the reference signal at a frequency f₁.

6. An electricity meter as claimed in any preceding claim comprising sampling means for repeatedly sampling the pulse-width modulated comparator output signals which includes a pair of counters responsive to respective output signals and to gating pulses of period 1/f₁ for counting pulses produced by a clock pulse oscillator at a frequency f₂ which is very much higher than f₁, during those parts of the period 1/f₁ when said output signals correspond to a 'mark', the counters being reset at the end of each 1/f₁ period, their respective counts immediately prior to each resetting operation being mutually multiplied and integrated thereby to provide the signal indicative of energy supplied.

7. An electricity meter as claimed in any of claims 3 to 6 wherein multiplication and integration functions are carried out in the micro-processor.

8. An electricity meter as claimed in claim 7 wherein additionally, the counting operations are carried out in the micro-processor.

9. An electricity meter as claimed in claim 7 wherein counter functions are at least partly carried out by appropriate hardware apparatus external of the micro-processor.

10. An electricity meter as claimed in any of claims 6 to 9 wherein the counters are 'offset' so that the effective count state is greater or less, as necessary, than a count state registered just prior to resetting.
